Europäisches Patentamt

European Patent Office

Office européen des brevets

(19)

(11)  **EP 1 333 427 A2**

## (12)    EUROPEAN PATENT APPLICATION

(43)  Date of publication:
**06.08.2003   Bulletin 2003/32**

(51)  Int Cl.⁷: **G11B 5/012**, G11B 5/09
      // G11B5/035, G11B19/02

(21)  Application number: **03100196.9**

(22)  Date of filing: **30.01.2003**

| | |
|---|---|
| (84)  Designated Contracting States:<br>**AT BE BG CH CY CZ DE DK EE ES FI FR GB GR**<br>**HU IE IT LI LU MC NL PT SE SI SK TR**<br>Designated Extension States:<br>**AL LT LV MK RO**<br><br>(30)  Priority:  **31.01.2002  US 353396**<br><br>(71)  Applicant: **Texas Instruments Incorporated**<br>**Dallas, Texas 75251 (US)** | (72)  Inventors:<br>• **Sharifi, Reza**<br>  **75025, Plano (US)**<br>• **Ranmuthu, Indumini W.**<br>  **75025, Plano (US)**<br><br>(74)  Representative: **Holt, Michael et al**<br>**Texas Instruments Ltd.,**<br>**EPD MS/13,**<br>**800 Pavilion Drive**<br>**Northampton Business Park,**<br>**Northampton NN4 7YL (GB)** |

(54)    **Circuit for reading differential data from a disk by applying a voltage bias on a read head**

(57)     Circuit, including a read circuit (418) to read the differential data from the disk by maintaining the voltage bias on the read head (164), an optimal voltage circuit (430) determining the optimal voltage bias to be applied to the read head (164), and a circuit (402) to apply said optimal voltage bias to the read head.

Figure 4

EP 1 333 427 A2

## Description

FIELD OF THE INVENTION

The present invention relates to disk circuits and, more particularly, to a differential circuit for reading differential data from a disk by a voltage bias on a read head, and associated disk system for reading information from a disk.

BACKGROUND OF THE INVENTION

Conventional magnetic storage devices include a magnetic transducer or "head" suspended in close proximity to a recording medium, for example a magnetic disk, having a plurality of concentric tracks. The transducer is supported by an air-bearing slider mounted to a flexible suspension. The suspension, in turn, is attached to a positioning actuator. During normal operation, relative motion is provided between the head and the recording medium as the actuator dynamically positions the head over the desired track. The relative movement provides an airflow along the surface of the slider facing the medium, creating a lifting force. The lifting force is counterbalanced by a predetermined suspension load so that the slider is supported on a cushion of air. Airflow enters the "leading" end of the slider and exits from the "trailing" end. This air is used to prevent the head from contacting the disk, resulting in damage.

Writing data is typically performed by applying a current to the coil of the head so that a magnetic field is induced in an adjacent magnetic permeable core, with the core transmitting a magnetic signal across any spacing and protecting coating of the disk to magnetize a small pattern or digital bit of the medium within the disk. Reading of the information in the disk is performed by sensing the change in magnetic field of the core as the transducer passes over the bits in the disk. The changing magnetic field induces a voltage or current in the inductively coupled coil. Alternatively, reading of the information may be accomplished by employing a magneto-resistive (MR) sensor, which has a resistance that varies as a function of the magnetic field adjacent to the sensor. In order to increase the amplitude and resolution in reading the bits, the MR sensor is typically positioned on the slider as close to the disk as possible and should be biased with appropriate current or voltage. Connected to these heads or sensors are read circuits which amplify the recorded data and eliminate noise. However, recently, some manufacturers of hard disk drives have switched from MR heads which are biased with a constant current source to MR heads which are biased with a constant voltage source. Consequently, there is a need for a read circuit which provides a constant voltage source instead of a constant current source. Characteristics of the head vary from head to head such as voltage current response. This presents a problem in a disk system that employs many of their heads. The bias circuit should bias the head to take into consideration these varying characteristics.

SUMMARY OF THE INVENTION

The present invention includes a biasing circuit to bias the head to take into consideration the characteristics of the individual head. During an initial phase, the present invention obtains the optimal bias for each head on the system. The optimal bias is measured by incrementally increasing the bias to the head until the optimal bias is reached. A comparator is used to compare the bias with a target voltage. The bias voltage is increased until the target voltage is reached. When the target voltage is reached a count from a counter circuit is stopped and saved. This count is used to generate the optimal voltage whenever the head is selected. This circuit is used for all heads in the disk system.

BRIEF DESCRIPTION OF THE DRAWINGS

Figure 1 illustrates a circuit in accordance with the teachings of the present invention;
Figure 2 is a side view of a disk drive system;
Figure 3 is a top view of a disk drive system; and
Figure 4 illustrates a circuit to determine the bias for the circuit of Figure 1.

DETAILED DESCRIPTION OF THE PRESENT INVENTION

The following invention is described with reference to figures in which similar or the same numbers represent the same or similar elements.

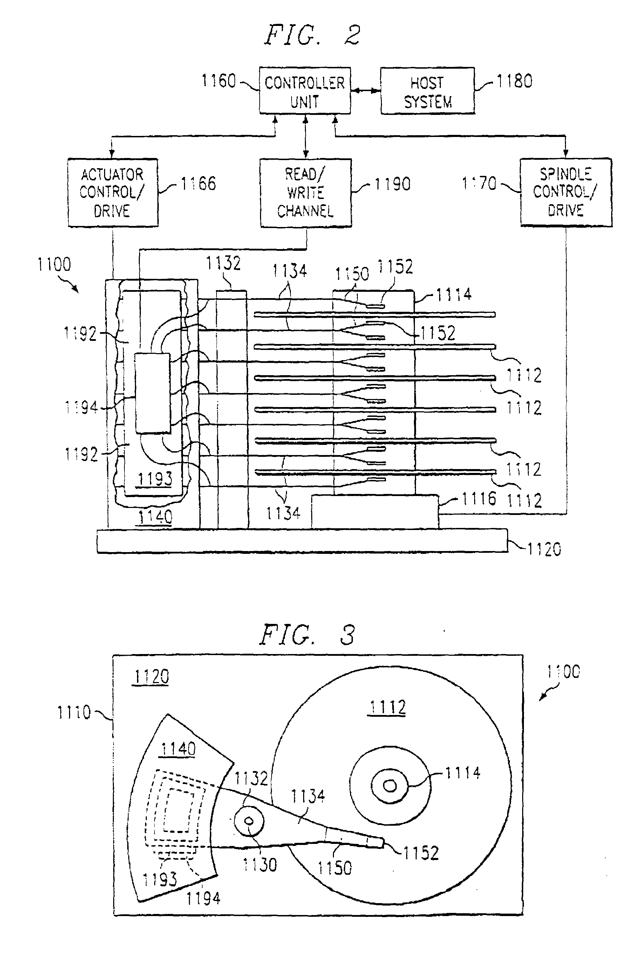

Figures 2 and 3 show a side and top view, respectively, of the disk drive system designated by the general reference 1100 within an enclosure 1110. The disk drive system 1100 includes a plurality of stacked magnetic recording disks 1112 mounted to a spindle 1114. The disks 1112 may be conventional particulate or thin film recording disk or, in other embodiments, they may be liquid-bearing disks. The spindle 1114 is attached to a spindle motor 1116 which rotates the spindle 1114 and disks 1112. A chassis 1120 is connected to the enclosure 1110, providing stable mechanical support for the disk drive system. The spindle motor 1116 and the actuator shaft 1130 are attached to the chassis 1120. A hub assembly 1132 rotates about the actuator shaft 1130 and supports a plurality of actuator arms 1134. The stack of actuator arms 1134 is sometimes referred to as a "comb." A rotary voice coil motor 1140 is attached to chassis 1120 and to a rear portion of the actuator arms 1134.

A plurality of head suspension assemblies 1150 are attached to the actuator arms 1134. A plurality of inductive transducer heads 1152 are attached respectively to the suspension assemblies 1150, each head 1152 including at least one inductive write element. In addition thereto, each head 1152 may also include an inductive read element or a MR (magneto-resistive) read element. The heads 1152 are positioned proximate to the disks 1112 by the suspension assemblies 1150 so that during operation, the heads are in electromagnetic communication with the disks 1112. The rotary voice coil motor 1140 rotates the actuator arms 1134 about the actuator shaft 1130 in order to move the head suspension assemblies 1150 to the desired radial position on disks 1112.

A controller unit 1160 provides overall control to the disk drive system 1100, including rotation control of the disks 1112 and position control of the heads 1152. The controller unit 1160 typically includes (not shown) a central processing unit (CPU), a memory unit and other digital circuitry, although it should be apparent that these aspects could also be enabled as hardware logic by one skilled in the computer arts. Controller unit 1160 is connected to the actuator control/drive unit 1166 which is in turn connected to the rotary voice coil motor 1140. A host system 1180, typically a computer system or personal computer (PC), is connected to the controller unit 1160. The host system 1180 may send digital data to the controller unit 1160 to be stored on the disks, or it may request that digital data at a specified location be read from the disks 1112 and sent back to the host system 1180. A read/write channel 1190 is coupled to receive and condition read and write signals generated by the controller unit 1160 and communicate them to an arm electronics (AE) unit shown generally at 1192 through a cut-away portion of the voice coil motor 1140. The read/write channel 1190 includes the phase lock loop of the present invention. The AE unit 1192 includes a printed circuit board 1193, or a flexible carrier, mounted on the actuator arms 1134 or in close proximity thereto, and an AE module 1194 mounted on the printed circuit board 1193 or carrier that comprises circuitry preferably implemented in an integrated circuit (IC) chip including read drivers, write drivers, and associated control circuitry. The AE module 1194 is coupled via connections in the printed circuit board to the read/write channel 1190 and also to each read head and each write head in the plurality of heads 1152. The AE module 1194 includes the read circuit of the present invention.

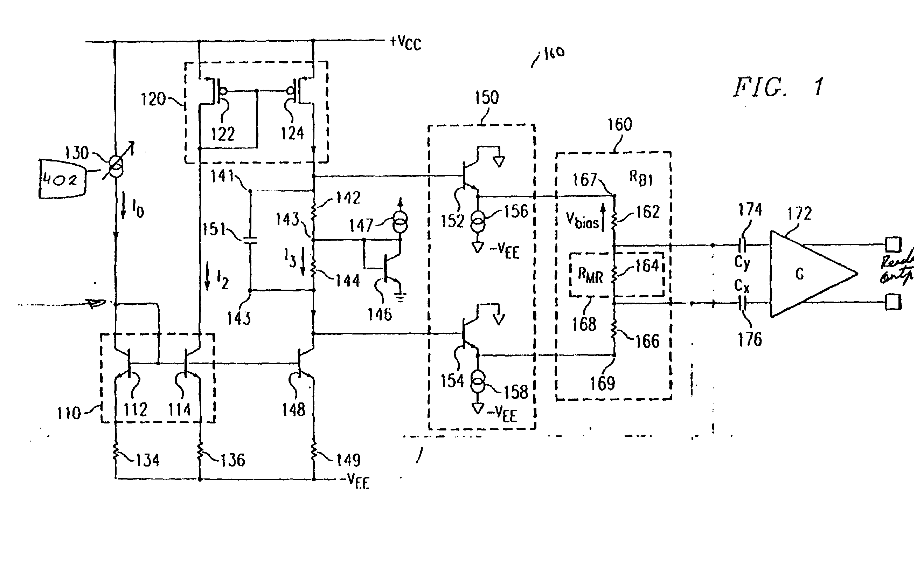

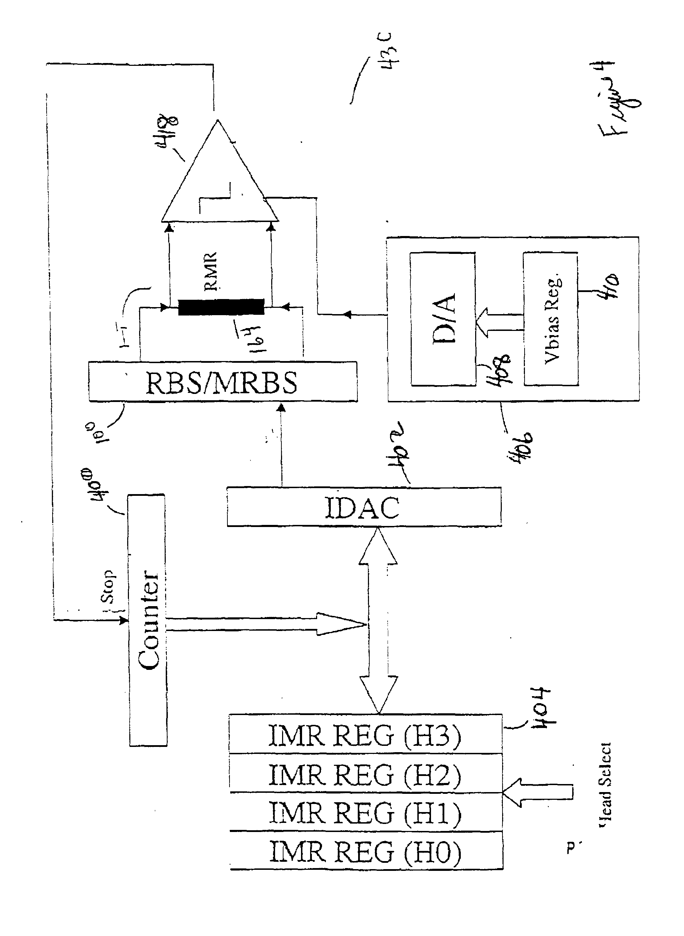

Figure 1 illustrates a constant voltage circuit for providing a constant voltage $V_{BIAS}$ across the read head to be used in the disk drive system. The present invention provides this constant voltage to a differential output circuit. The constant voltage circuit to produce a differential current output is illustrated in Figure 1. This constant voltage circuit includes a first current path through transistor 112 and variable current generator 130, a second current path through transistor 114 and through transistor 122, and a third current path through FET 124, resistor 142, resistor 144, transistor 148 and resistor 149. In addition, the constant voltage circuit, as illustrated in Figure 1, includes a voltage reduction circuit 160, a voltage dividing circuit 150, a current mirror circuit 110, and a second current mirror circuit 120. The first current path includes a variable current generating circuit 130 to generate a current $I_0$ to flow in a portion of the first current path. The variable current generator 130 is controlled by control circuit 402 illustrated in Figure 4. In addition, variable current generator 130 is connected to voltage $V_{cc}$ and connected to the collector of transistor 112. Additionally, the first current path includes the transistor 112 and resistor 134. The second current path includes FET device 122 which is a PFET device having a source connected to voltage $V_{cc}$, a gate connected to the drain of PFET 122. The current $I_2$ flows along the second current path and through the collector to emitter of transistor 114 and through resistor 136. In addition, the circuit illustrates a third current path including a FET 124 being illustrated as a PFET device with a source connected to voltage $V_{cc}$, the gate connected to the gate of PFET 122 and the drain of PFET 124 being connected to capacitor 151 and resistor 142. The resistor 142 is additionally connected to resistor 144, and the other end of resistor 144 is connected to another end of capacitor 151. Both capacitor 151 and resistor 144 are connected to the collector of transistor 148. The emitter of transistor 148 is connected to resistor 149. The other end of resistor 149 is connected to voltage $V_{EE}$, for example a negative 5V supply.

Additionally, transistor 146 is connected between resistors 142 and 144. More particularly, the base and collector of transistor 146 is connected between resistors 142 and 144. The emitter of transistor 146 is connected to ground. The collector and base of transistor 146 is connected to current generator 147. The current generator generates a small amount, in this example 100 μA, of current so that the transistor 146 is biased to produce a voltage drop, in this example $1V_{BE}$, with respect to ground. The voltage driver circuit 150 reduces the common mode voltage by $1V_{BE}$ at the terminal between resistor 142 and PFET 124 and at the terminal between resistor 144 and transistor 148. The collector of transistor 152 is connected to voltage $V_{cc}$. Likewise, with transistor 154, the base is connected at the terminal between transistor 148 and resistor 144. The collector of transistor 154 is connected to voltage $V_{cc}$. The emitter of transistor 154 is connected to a current generator. Additionally, the emitter is connected to resistor 166. The current generator 156 and 158 operate to bias the transistors 154 and 152, respectively, such that the base-to-emitter voltage of the respective transistors 152 and 154 is $1V_{BE}$. The resistor 162 is connected to the emitter of transistor 152. The resistance 162 is connected to the head 168 of the disk drive system. The head 168 includes a resistor 164, representing the resistance of the head, connected to the resistor 162. The resistor 164 is connected to resistor 166, and the other end of resistor 166 is connected to the emitter of transistor 154. Additionally, the capacitor 174 is connected between resistor 164 and resistor 162. The capacitor 176 is connected between resistor 164 and resistor 166. The capacitors 174 and 176 are decoupling capacitors to decouple the DC bias from the read head. The capacitors 174 and 176 are connected to amplifier 172 which amplifies the signal for the read channel.

In operation, current $I_0$ which is variable and controlled by current DAC 402 flows through a first portion of the first current path and is output from current generator 130. This current $I_0$ is mirrored by current mirror circuit 110 to the second current path, and the mirrored current is illustrated in Figure 1 as $I_2$. This current $I_2$ is mirrored to the third current path by current mirror circuit 120. This current is illustrated in Figure 1 as current $I_3$, which flows in the third current path, which flows through resistor 142, resistor 144 and transistor 148. The current $I_3$ flows through resistors 142 and 144 to form a voltage between terminals 141 and 143. The voltage $V_{CN}$ is equal to $I_3 \times (R_{142} + R_{143})$. Since $I_3$ is equal to $I_0 + I_{TUNE}$,

$$V_{CN} = I_0 \times (R_1 + R_2) \qquad (1)$$

Typically, the resistance value of resistor 142 and the resistance value of resistor 144 are the same. The transistor 146 is connected with an emitter-to-ground connection to establish the center of head 168 is at ground potential. Node 143 will be at $1V_{BE}$ above ground as a result of transistor 146. Thus, the voltage at terminal 141 and the voltage at terminal 143 are at $1V_{BE}$ above ground since the resistance of resistor 142 is equal to the resistance of resistor 144.

The voltage during circuit 150 reduces the voltage of $V_{CN}$ by one $V_{BE}$. More particularly, the transistor 152 reduces the voltage at terminal 141 by one $V_{BE}$, and the transistor 154 reduces the voltage at terminal 143 by one $V_{BE}$. As a consequence, the voltage across terminals 167 and 169 are the same voltage as the voltage across terminals 141 and 143. In addition, the center of the head 168 is at ground potential. The current through resistors 162, 164 and 166 is determined by equation 2.

$$I_{MR} = \frac{V_{CN}}{R_{162} + R_{164} + R_{166}} \qquad (2)$$

Therefore, the voltage across the head $V_{BIAS}$ equals equation 3.

$$V_{BIAS} = I_{MR} \times R_{168} \qquad (3)$$

Thus, the voltage across the head 168 is maintained by the current $I_{MR}$.

Turning now to Figure 4, the optimal voltage circuit 430 illustrates the circuit 100 of Figure 1 connected to the RMR head represented by element 164. A comparator 418 is connected at each end of the RMR head 164 to measure the differences in voltage across the RMR head 164. The comparator 418 compares the voltage across RMR head 164 with the output of voltage generator circuit 406 which is referred to as a target voltage. The output of the comparator 418 is input to a counter 400, the counter 400 is an up-counter. The output of counter 400 is input via a bus to a current IDAC circuit 402 and to register 404 which could be a set of flip flops. The current DAC 402 outputs a current to the circuit 100, more particularly to the variable current generator 130 illustrated in Figure 1. During startup, the voltage generating circuit 406 includes a register 410 to store the target voltage, and a digital to analog converter 408 converts the digital voltage to analog. The voltage generating circuit 406 generates an optimal voltage ($V_{BIAS}$) that should be placed across the RMR head 164. The voltage is input to digital to analog converter 408 which generates an analog voltage corresponding to $V_{BIAS}$ which is input to comparator 418. The voltage across RMR head 164, which is initially 0, is compared to the optimal voltage. An output, a logical ' I ', from comparator 418 is input to counter 400 when no match is obtained between the comparison of the optimal voltage and the voltage across the RMR head 164. The output from the comparator 418 starts the counter 400 to begin counting up from zero. The count, which is output from counter 400, is input to current DAC 402. The current DAC 402 translates the count output from counter 400 to a current which is input to the variable current generator 130. As described above, the current $I_o$ is translated to $V_{BIAS}$ across head RMR 164. Thus an increase in current $I_o$ results in an increase voltage $V_{BIAS}$ across the RMR head 164. The voltage across the RMR 164 is again compared with the comparator 418 and still no match is obtained with comparator 418, and consequently a logical 1 is output from comparator 418 to counter 400. The counter 400 continues to count up which increases the current-to-current generator 130. At a particular time, the current output from current generator 130 is sufficient to cause the voltage across the RMR head 120 to equal the optimal voltage output from the voltage generation circuit 406. At which time the comparator 418 output a logical 0 which stops the counter 400 from counting up. The value of the counter 400 is input to the register 404 at a register corresponding to the particular head being initialized. A head select signal selects the appropriate register in register 404. This operation is repeated for each head of the disk system in any particular order so that all the heads in the disk system all have been initialized as described above. During operation of the disk system, the comparator 418 is inactivated, the voltage generation circuit 406 is inactivated, and the counter 400 is inactivated. A particular head, for example head 2 (H2) is selected and the stored counter output from register 2 is input along a bus to current DAC 402. The current DAC 402 generates a current corresponding to the count in the register associated with head 2. A current $I_0$ is generated by current generator 130 under control of current DAC 402. The current $I_0$ places the optimal voltage across RMR head 164 and the head is biased to a voltage corresponding to the optimal amount. Thus, a current mode solution is achieved in that an accurate value of the bias voltage is represented by a current and thus an accurate representation of the bias voltage is achieved. Additionally, this allows for fast head switch time in that no initialization is required for the RMR head 164 which is switching from head to head. Additionally, the circuit is less prone to coupling and noise.

The present invention eliminates the need for a feedback circuit. The current $I_0$ is controlled to be the optimal current to generate the optimal voltages $V_{BIAS}$.

It will be appreciated by those skilled in the art that variations may be accomplished in view of these teachings without deviation from the scope of the invention.

## Claims

1. A differential circuit for reading differential data from a disk by a voltage bias on a read head, comprising:

   a read circuit for reading said differential data from said disk by maintaining said voltage bias on said read head;
   an optimal voltage circuit for determining the optimal voltage bias to be applied to said read head; and
   a circuit for applying said optimal voltage bias to said read head.

2. A differential circuit as in Claim 1 wherein said optimal voltage circuit includes a counter circuit for generating counts to represent said voltage bias.

3. A differential circuit as in Claim 2 wherein said optimal voltage circuit includes a register for stop ping said counts from being counted.

4. A differential circuit as in any one of Claims 1 to 3 wherein said optimal voltage circuit includes a comparator for comparing said voltage bias with a target voltage.

5. A differential circuit as in any one of Claims 2 to 4 wherein said optimal voltage circuit includes the or a comparator for controlling said counter circuit.

6. A disk system for read ing information from a disk, comprising:

   a read/write head for reading and writing information from said disk;

   a read channel for processing said information; and
   a differential circuit for reading differential data from a disk by a voltage bias, comprising:

   an optimal voltage circuit for determining the optimal voltage bias to be applied to said read head; and
   a circuit for applying said optimal voltage bias to said read head.

7. A disk system as in Claim 6 wherein said optimal voltage circuit includes a counter circuit for generating counts to represent said voltage bias.

8. A disk system as in Claim 7 wherein said optimal voltage circuit includes a register for stop ping said counts from being counted.

9. A disk system as in any one of Claims 6 to 8 wherein said optimal voltage circuit includes a comparator for comparing said voltage bias with a target voltage.

10. A disk system as in any one of Claims 7 to 9 wherein said optimal voltage circuit includes the or a comparator for controlling said counter circuit.

FIG. 1

$+V_{CC}$

$R_{B1}$

$R_{MR}$

$V_{bias}$

$G$

$C_y$  $C_x$

$-V_{EE}$

$-V_{EE}$

$I_0$  $I_2$  $I_3$

160  162  164  166  167  168  169

150  152  154  156  158

120  122  124

110  112  114

130  402

134  136  140  141  142  143  144  145  146  147  148  149  151

170  172  174  176

## FIG. 2

## FIG. 3

7

EP 1 333 427 A2

Stop

400

100

Counter

RBS/MRBS

RMR

164

418

43C

IDAC

402

IMR REG (H3)

IMR REG (H2)

IMR REG (H1)

IMR REG (H0)

404

Head Select

D/A

Vbias Reg.

406

408

410

Figure 4